# EUROPÄISCHE PATENTSCHRIFT

(11) **EP 0 538 578 B1**
(45) Veröffentlichungstag und Bekanntmachung des Hinweises auf die Patenterteilung: **28.05.1997**
(21) Anmeldenummer: 92114021.6
(22) Anmeldetag: 17.08.1992
(51) Int. Cl.: G01R 15/00, H01F 38/28, H01F 27/42, G01R 19/20

(54) **Stromsensor nach dem Kompensationsprinzip**
Compensation principle current sensor
Capteur de courant selon le principe de la compensation

(30) Priorität: 18.09.1991 DE 4130999
(43) Veröffentlichungstag der Anmeldung: 28.04.1993
(73) Patentinhaber: Vacuumschmelze GmbH, 63450 Hanau (DE)
(72) Erfinder: Lenhard, Friedrich, Dipl.-Ing., W-6450 Hanau 1 (DE)
(74) Vertreter: Fuchs, Franz-Josef, Dr.-Ing.

(56) Entgegenhaltungen:
- EP-A- 0 294 590
- DD-A- 231 884
- G.-P. SCHERNUS 'Potentialfreie digitale Messung von Gleichströmen' 1975 , DISSERTATION, TU , BRAUNSCHWEIG

## Beschreibung

Die Erfindung betrifft einen Stromsensor nach dem Kompensationsprinzip, bei dem das in einem Magnetkern von einer von dem zu messenden Strom durchflossenen Primärwicklung erzeugte Magnetfeld durch den Kompensationsstrom in einer Sekundärwicklung kompensiert wird, wobei zur Steuerung des Kompensationsstromes mindestens ein streifenförmiger, mit einer Indikatorwicklung versehener Meßkern aus weichmagnetischem Material parallel zu einem Teil des Magnetkerns so angeordnet ist, daß er einerseits von dessen Magnetfeld und andererseits von einem Wechselstrom in der Indikatorwicklung magnetisierbar ist, und daß in einer Auswerteschaltung zur Auswertung des Wechselstromes in der Indikatorwicklung dessen durch die vom Magnetkern verursachte Vormagnetisierung des Meßkerns bedingte Unsymmetrie zur Bestimmung des Kompensationsstromes ausgewertet wird.

Ein derartiger Stromsensor ist im Prinzip aus EP-294590 A2 bekannt. Bei diesem Stromsensor werden die Amplituden des in einer Indikatorwicklung fließenden Stromes getrennt für die positive und die negative Halbwelle verglichen. Je nach dem, wie der Meßkern - hier streifenförmiges Element genannt - durch den Magnetfluß im Magnetkern vormagnetisiert wird, erhält man am Ausgang einer Auswerteschaltung ein positives oder negatives Signal, das über einen Verstärker auf die Kompensationswicklung des Magnetkreises gegeben wird.

Aufgabe der vorliegenden Erfindung ist es, einen derartigen Stromsensor nach dem Kompensationsprinzip so zu ertüchtigen, daß er auch bei relativ hohen Überströmen selbst dann seine Meßfunktion beibehält, wenn sich Sättigungserscheinungen in dem für die Auswertung vorgesehenen Magnetkern einstellen. Diese Aufgabe wird erfindungsgemäß dadurch gelöst, daß die Windungen der Indikatorwicklung in dem Bereich des streifenförmigen Meßkerns, der von dem Magnetfeld des Magnetkerns am meisten beeinflußt wird, weniger dicht, d. h. weniger Windungen pro Längeneinheit, gewickelt sind als in den übrigen Bereichen.

In den Zeichnungen ist ein Ausführungsbeispiel der Erfindung näher dargestellt.
- Fig. 1: zeigt die Schaltung des Stromsensors im Prinzip mit der elektronischen Auswerteeinrichtung,
- Fig. 2a: zeigt die erfindungsgemäße Bewicklung,
- Fig. 2b: eine übliche Bewickung des Meßkerns und in
- Fig. 3: ist die durch die Vormagnetisierung des Magnetkerns erzeugte Differenzspannung dargestellt, wie sie sich abhängig von den unterschiedlichen Bewicklungsarten ergibt,
- Fig. 4: zeigt ein Ausführungsbeispiel des Magnetkerns mit parallel zu einem Luftspalt angeordnetem Meßkern.

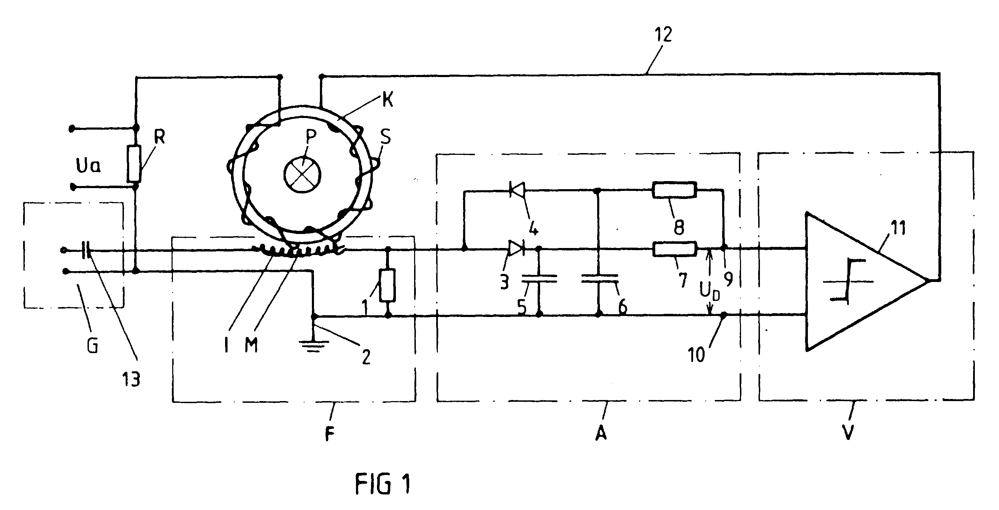

In Figur 1 ist einem Wechselspannungsgenerator G ein Feldsensor F so nachgeschaltet, daß der vom Wechselspannungsgenerator G gelieferte Strom über eine Indikatorwicklung I und einen Widerstand 1 zur Erde 2 fließt. Hierdurch entsteht an den Klemmen des Widerstandes 1 eine Spannung, die dem Strom in der Indikatorwicklung I proportional ist. Die Indikatorwicklung I umschließt dabei einen Meßkern M, der außer von dem Strom in der Indikatorspule I auch von dem Magnetfluß in einem Magnetkern K beeinflußt wird.

Die an den Klemmen des Widerstands 1 entstehende Spannung wird nun einer Auswerteeinrichtung A zugeführt. Diese besteht aus zwei antiparallel geschalteten Dioden 3 und 4, die über Kondensatoren 5 und 6 mit Erde 2 verbunden sind. Die Dioden 3 und 4 liegen in Reihe zu Widerständen 7 und 8, die beide an eine Ausgangsklemme 9 der Auswerteschaltung angeschlossen sind. Die zweite Ausgangsklemme 10 der Auswerteschaltung ist wiederum mit Erde 2 verbunden.

Der Auswerteschaltung A ist nun eine Verstärkerschaltung V nachgeschaltet, die man auch als Regler mit Sollspannung nicht zwischen den Ausgangsklemmen 9 und 10 der Auswerteschaltung bezeichnen könnte. Die Verstärkerschaltung besteht im wesentlichen aus einem Verstärker 11, der schon bei sehr kleinen Werten der Eingansspannung seine maximale Ausgangsspannung abgibt - also einen sehr hohen Verstärkungsfaktor aufweist.

Der Verstärker 11 ist über eine Leitung 12 mit der Sekundärwicklung S des Magnetkerns K verbunden. Durch die Sekundärwicklung S fließt damit der Kompensationsstrom, der ein Maß für den Strom in der Primärwicklung P des Magnetkerns K darstellt. Der zweite Anschluß der Sekundärwicklung S ist über einen Meßwiderstand R wiederum mit Erde verbunden, so daß an dem Meßwidertand R eine Spannung abfällt, die dem Strom in der Sekundärwicklung und damit auch dem Strom in der Primärwicklung P proportional ist. Diese Spannung ist hier mit Ua bezeichnet.

Im vorgestellten Schaltungsbeispiel ist innerhalb des Wechselspannungsgenerators G ein Reihenkondensator 13 vorgesehen, so daß der Wechselspannungsgenerator G sowohl in der positiven als auch in der negativen Halbwelle jeweils die gleiche Stromzeitfläche aufweist - also keinen Gleichstromanteil enthält.

Wenn die Frequenz des Wechselspannungsgenerators G gegenüber der Frequenz in der Primärwicklung P sehr hoch ist, wird sich die Vormagnetisierung des Meßkerns während mehrerer Ummagnetisierungsperioden des Meßkerns M kaum ändern. Zur Erläuterung der Wirkungsweise kann also die durch den Meßstrom in der Primärwicklung P erzeugte Vormagnetisierung des Meßkerns M als konstant angenommen werden. Diese Vormagnetisierung ergibt sich durch die Differenz der von der Primärwicklung P und der Sekundärwicklung S erzeugten Flüsse im Magnetkern K und bewirkt, daß der Meßkern M entweder während der positiven oder der negativen Halbwelle des Stromes in der Indikatorwicklung weiter in die Sättigung ummagnetisiert wird.

Es wird also - auch abhängig von der Kurvenform der vom Wechselspannungsgenerator G gelieferten Spannung - die positive und negative Halbwelle des Stromes in der Indikatorwicklung I ( = Spannungsabfall am Widerstand 1) verschieden verformt. Die Halbwellen erhalten damit unter anderem unterschiedliche Maximalwerte, deren Differenz ein Maß für die Vormagnetisierung des Meßkernes darstellt. Anstelle einer bestimmten Wechselspannung könnte der Wechselspannungsgenerator G auch einen eingeprägten Strom liefern.

Diese unterschiedlichen Spannungsamplituden der Halbwellen werden nun in der Auswerteschaltung A ausgewertet. Der Kondensator 5 wird über die Diode 3 auf eine Spannung aufgeladen, die etwa der Amplitudenspannung der positiven Halbwelle entspricht, und über die Diode 4 wird der Kondensator 6 auf eine Spannung aufgeladen, die der negativen Amplitudenspannung des Spannungsabfalls am Widerstand 1 im Feldsensor F entspricht.

Durch die Widerstände 7 und 8 wird die Differenz beider Spannungen an den Kondensatoren 5 und 6 gebildet. Diese Differenzspannung UD stellt damit die Ausgangsspannung der Auswerteeinrichtung A dar. Die Differenzspannung verändert über den Verstärker 11 in der Verstärkerschaltung V den Kompensationsstrom in der Sekundärwicklung S und damit den Spannungsabfall am Meßwiderstand R so lange, bis die Vormagnetisierung des Meßkerns M verschwindet und damit die Ausgangsspannung der Auswerteschaltung A zu Null wird.

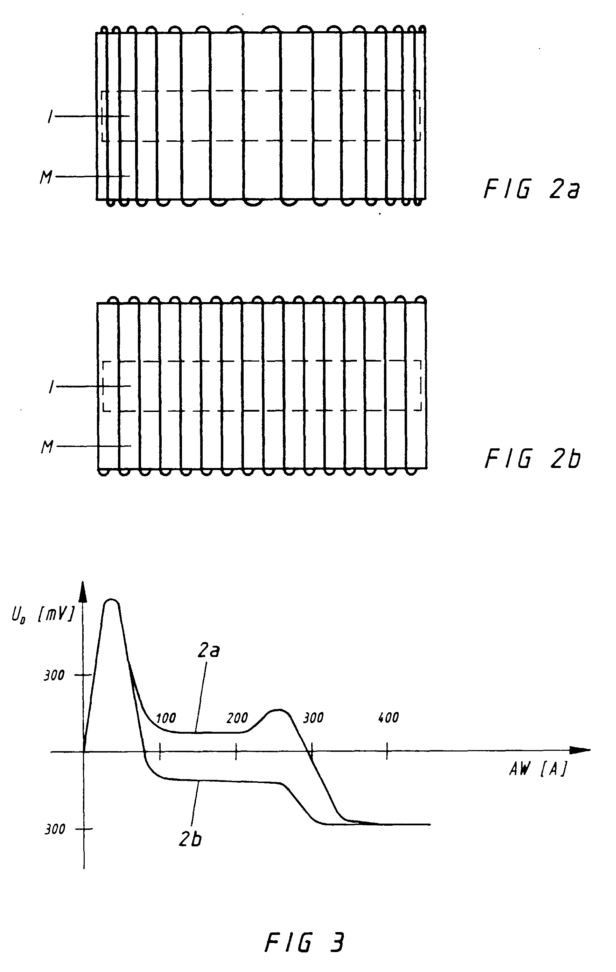

Die Differenzspannung UD ist also dann immer verschieden von Null, wenn der Kompensationsstrom von seinem Sollwert abweicht. Um diese Abweichung möglichst schnell und genau auszuregeln, ist es erforderlich, daß schon bei kleinster Vormagnetisierung ein steiler Anstieg der Differenzspannung UD und damit eine schnelle Änderung des Kompensationsstromes in der Sekundärwicklung S erfolgt. Der Einfluß der erfindungsgemäßen Bewicklung des Meßkerns M wird nun anhand der Fig. 2 und 3 näher erläutert.

Fig. 2a zeigt einen Meßkern M mit einer Indikatorwicklung I, die an den Enden des Meßkerns wesentlich dichter gewickelt ist als in dessen Mitte. Fig. 2b zeigt wiederum den Meßkern M mit einer Indikatorwicklung I, deren Windungszahlen gleichmäßig über die Länge des Magnetkerns M aufgebracht sind. Der Verlauf der Differenzspannung UD im nicht kompensierten Zustand des Stromsensors, abhängig von der Bewicklung des Meßkerns M zeigt nun Fig. 3. Hier ist die Differenzspannung UD aufgetragen in Abhängigkeit von der Amperewindungszahl AW, mit der der Magnetkern K beaufschlagt wird. Diese Amperewindungszahl ist damit ein Maß des im Magnetkern K vorhandenen Magnetfeldes. Zur Messung dieses Verlaufs der Differenzspannung UD wurde die Leitung 12 in Fig. 1 aufgetrennt und damit eine Kompensation bzw. ein Ausregeln des Stromsensors unterbunden und ein Magnetfeld durch Aufbringen eines Stromes (Amperewindungszahl AW) eingestellt.

Man sieht, daß bei geeigneter Wahl der Spannung des Wechselspannungsgenerators G und der Windungszahl der Indikatorwicklung I bei kleinen Magnetfeldern ein steiler Anstieg der Differenzspannung UD auftritt. Dies gilt sowohl für die Kurve 2a, die mit einem entsprechend Fig. 2 bewickelten Meßkern M aufgenommen wurde, als auch für die Kurve 2b, die sich mit einem entsprechend der Fig. 2b bewickelten Meßkern M ergibt. Beide Kurven erreichen dann bei etwa 50 AW ein Maximum, so daß sich bei weiterer Erhöhung des Magnetfeldes im Magnetkern K nunmehr eine Verringerung der Differenzspannung UD ergibt. Die Ursache dieses Effektes ist eine zunehmende Sättigung des Meßkerns M, die zunächst auftritt, wenn der Strom der Indikatorwicklung ein Magnetfeld in Richtung der Vormagnetisierung durch den Magnetkern erzeugt und die bei größer werdendem Magnetfeld im Magnetkern K auch dann auftritt, wenn das Magnetfeld durch den Strom in der Indikatorwicklung der Vormagnetisierung entgegengerichtet ist.

Falls das Magnetfeld im Magnetkern K so groß wird, daß der Meßkern M ständig gesättigt ist, fällt theoretisch die Differenzspannung UD auf den Wert Null, da in keiner der beiden Halbwellen des Stromes des Wechselstromgenerators G eine Magnetisierungsänderung im Meßkern M erfolgt. Bedingt durch Unsymmetrien in der für die Messung eingesetzten Auswerteeinrichtung A ergibt sich jedoch ein Kurvenverlauf entsprechend der Kurve 2b, wenn der Meßkern M gleichmäßig bewickelt ist. Dies hat zur Folge, daß - wie in dem gewählten Beispiel - sogar negative Differenzspannungen auftreten können, die im Betriebsfall des Stromsensors dazu führen würden, daß der Verstärker 11 den Strom in der Sekundärwicklung so regeln würde, daß sich das Magnetfeld im Magnetkern K nicht kompensiert, sondern im Gegenteil noch verstärkt. Damit wäre der Stromsensor funktionsunfähig.

Dies kann im Betrieb auftreten, wenn entweder sehr hohe Überströme in der Primärwicklung P fließen oder sich - beispielsweise im Kurzschlußfalle - sehr schnelle Stromänderungen ergeben. Um dies zu vermeiden, müßte man sehr aufwendige Auswerteeinrichtungen A entwickeln, die auf keinen Fall irgendwelche Unsymmetrien aufweien dürften. Oder man könnte den vom Wechselspannungsgenerator G gelieferten Strom soweit erhöhen, daß auch bei relativ großem Magnetfeld im Magnetkern K der Meßkern M nicht immer gesättigt ist. Dies hätte allerdings zur Folge, daß auch im kompensierten Zustand der Meßkern M durch den vergrößerten Strom des Wechselspannungsgenerators G in der positiven und in der negativen Halbwelle in die Sättigung getrieben würde, so daß kleine Magnetfelder im Magnetkern K nur geringe Auswirkungen auf die Differenzspannung UD hätten. Die an sich gewünschte hohe Empfindlichkeit des Stromsensors im Bereich des Magnetfeldes Null im Magnetkern K würde damit verringert. Der gleiche Effekt würde sich ergeben, wenn man anstelle einer Erhöhung des vom Wechselspannungsgenerator G gelieferten Stromes die Windungszahl der Indikatorwicklung I erhöhen würde.

Hier schafft die Erfindung Abhilfe. Sie macht sich die Erkenntnis zunutze, daß bei einem streifenförmigem Meßkern M, der parallel zu einem Teil des Magnetkerns K liegt, die Magnetfeldlinien über die Länge des Meßkerns M verteilt in diesen eintreten.

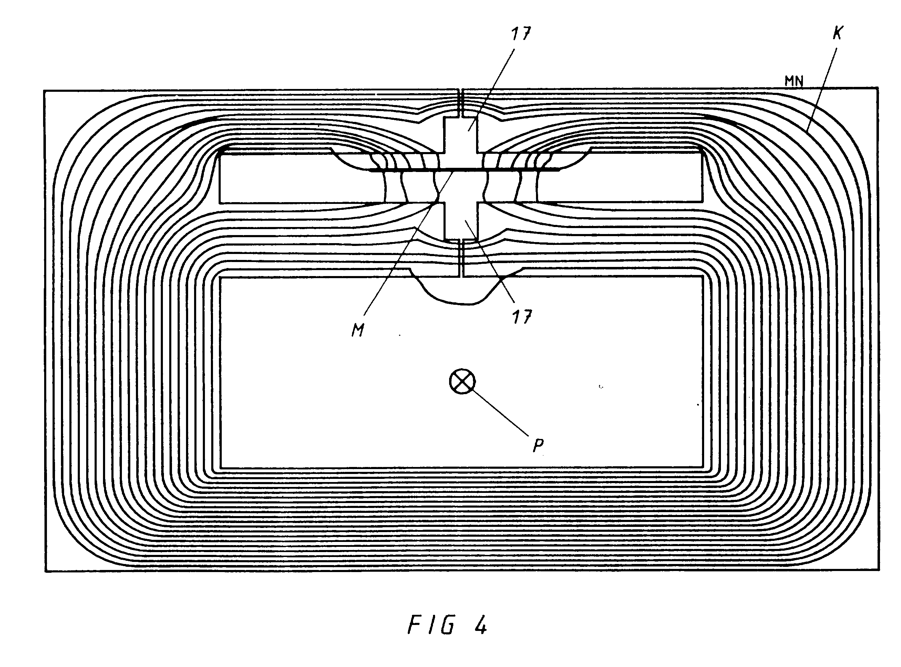

Diese Anordnung zeigt Fig. 4, bei der ein rechteckförmiger Magnetkern K dargestellt ist, dessen Magnetfeld durch einen Strom in der Primärwicklung P erzeugt wird und dessen Magnetfeldlinien in einem parallel zu einem Luftspalt 17 angeordneten Meßkern M eintreten. Hieraus ist zu ersehen, daß der Meßkern M bei steigendem Magnetfeld im Magnetkern K zunächst in der Mitte und erst später an den Enden gesättigt wird. Damit ergibt sich abhängig von der Bewicklung des Magnetkerns M folgende Wirkungsweise: Wenn der Meßkern M nicht gesättigt ist, ergeben die Bewicklungen nach den Fig. 2a und 2b jeweils den gleichen Effekt, da bei einer Stromänderung in den Windungen der Indikatorwicklung I die dadurch erzeugte Spannung an den Enden der Indikatorwicklung unabhängig davon ist, wo sich die Windungen auf dem Meßkern M befinden. Ist dieser jedoch in der Mitte gesättigt, während die Enden des Meßkerns M noch nicht gesättigt sind, so tragen nur die an den Enden des Meßkerns befindlichen Windungen der Indikatorwicklung I etwas zu der sich an den Enden dieser Wicklung ergebenden Spannung bei. Hierdurch ergibt sich bei einer unsymmetrischen Bewicklung des Meßkerns M entsprechend Fig. 2a in Fig. 3 der durch Kurve 2a dargestellte Verlauf, d. h., trotz einer Unsymmetrie in der Auswerteeinrichtung A bleibt im Bereich bis 300 AW die Differenzspannung UD positiv und nähert sich erst dann dem Verlauf der Kurve 2b ab etwa 380 Amperewindungen. Dies ist der Punkt, wo der Meßkern M unabhängig von der Bewicklung auch an den Enden gesättigt ist, so daß sich bei idealer Auswerteeinrichtung eine Spannung Null ergeben würde. Durch unvermeidbare Unsymmetrien bleibt jedoch eine Restspannung erhalten, die im gewählten Beispiel negativ ist.

Hieraus ist zu sehen, daß durch die erfindungsgemäße Bewicklungsart des Meßkerns M eine eindeutige Verbesserung des Regelverhaltens eines Stromsensors mit Kompensationswicklung erzielt werden kann.

## Patentansprüche

1. Stromsensor nach dem Kompensationsprinzip, bei dem das in einem Magnetkern (K) von einer von dem zu messenden Strom durchflossenen Primärwicklung (P) erzeugte Magnetfeld durch den Kompensationsstrom in einer Sekundärwicklung (S) kompensiert wird, wobei zur Steuerung des Kompensationsstromes mindestens ein streifenförmiger, mit einer Indikatorwicklung (I) versehener Meßkern (M) aus weichmagnetischem Material parallel zu einem Teil des Magnetkerns (K) so angeordnet ist, daß er einerseits von dessen Magnetfeld und andererseits von einem Wechselstrom in der Indikatorwicklung (I) magnetisierbar ist, und daß in einer Auswerteschaltung (A) zur Auswertung des Wechselstromes in der Indikatorwicklung (I) dessen durch die vom Magnetkern (K) verursachte Vormagnetisierung des Meßkerns (M) bedingte Unsymmetrie zur Bestimmung des Kompensationsstromes ausgewertet wird, **dadurch gekennzeichnet ,** daß die Windungen der Indikatorwicklung (I) in dem Bereich des streifenförmigen Meßkerns (M), der von dem Magnetfeld des Magnetkerns (K) am meisten beeinflußt wird, weniger dicht, d. h. weniger Windungen pro Längeneinheit, gewickelt sind als in den übrigen Bereichen.

2. Stromsensor nach Anspruch 1, **dadurch gekennzeichnet,** der streifenförmige Meßkern (M) parallel zu einem Luftspalt (17) im Magnetkern (K) so angeordnet ist, daß sich der mit geringerer Windungsdichte versehene Teil des Meßkerns (K) in der Nähe des Luftspaltes befindet.

3. Stromsensor nach Anspruch 1, **dadurch gekennzeichnet,** daß sich der Bereich des Meßkerns (K) mit geringerer Windungsdichte in dessen Mitte befindet.

## Claims

1. Current sensor based on the compensation principle, in which the magnetic field produced in a magnet core (K) of a primary winding (P) through which the current to be measured flows is compensated by the compensation current in a secondary winding (S), at least one strip-shaped measuring core (M), which is made of soft magnetic material and is provided with an indicator winding (I), being, in order to control the compensation current, arranged parallel to a part of the magnet core (K) in such a way that it can be magnetized, on the one hand by the magnetic field of this magnet core and on the other hand by an alternating current in the indicator winding (I), and that, in an evaluation circuit (A) for evaluating the alternating current in the indicator winding (I), the asymmetry in the latter, due to the premagnetization of the measuring core (M) due to the magnet core (K) is evaluated in order to determine the compensation current, characterized in that the turns of the indicator winding (I) are less dense in that region of the strip-shaped measuring core (M) which is affected most by the magnetic field of the magnet core (K), that is to say fewer turns per unit length are wound than in the other regions.

2. Current sensor according to Claim 1, characterized in that the strip-shaped measuring core (M) is arranged parallel to an air gap (17) in the magnet core (M), in such a way that a part of the measuring core (K) provided with a lower turns density lies in proximity to the air gap.

3. Current sensor according to Claim 1, characterized in that the region of the measuring core (K) with a lower turns density lies at the centre of this measuring core.

## Revendications

1. Capteur de courant selon le principe de la compensation, dans lequel le champ magnétique créé dans un noyau magnétique (K) par un enroulement primaire (P) traversé par le courant à mesurer est compensé par le courant de compensation dans un enroulement secondaire (S), dans lequel, pour la commande du courant de compensation, au moins un noyau de mesure (M) sous forme de bande, pourvu d'un enroulement indicateur (I) et fait d'un matériau magnétique doux est situé de manière parallèle à une partie du noyau magnétique (K), de manière à ce qu'il puisse être magnétisé d'une part par le champ magnétique de celui-ci et d'autre part par un courant alternatif dans l'enroulement indicateur (I), et à ce que, dans un circuit d'analyse (A) destiné à analyser le courant alternatif dans l'enroulement indicateur (I), la dissymétrie du noyau de mesure (M) due à la prémagnétisation de ce dernier causée par le noyau magnétique (K) soit analysée en vue de déterminer le courant de compensation, caractérisé en ce que les spires de l'enroulement indicateur (I) sont enroulées de manière moins serrée dans la zone du noyau de mesure (M) en forme de bande qui est la plus influencée par le champ magnétique du noyau magnétique (K), c'est-à-dire que moins de spires y sont enroulées par unité de longueur que dans les autres zones.

2. Capteur de courant selon la revendication 1, caractérisé en ce que le noyau de mesure (M) en forme de bande est disposé de manière parallèle à un entrefer (17) dans le noyau magnétique (K), de manière à ce que la partie du noyau de mesure (K) présentant une plus faible densité de spires se trouve à proximité de l'entrefer.

3. Capteur de courant selon la revendication 1, caractérisé en ce que la zone du noyau de mesure (K) ayant une densité de spires plus faible se trouve en son milieu.
